# EUROPEAN PATENT APPLICATION

(11) **EP 4 841 677 A1**
(43) Date of publication of application: **18.11.2026**
(21) Application number: 25382498.1
(22) Date of filing: 16.05.2025
(51) Int. Cl.: H01L 23/498, H01L 23/00, H01L 21/48

(54) **CHIP MODULE, CARD-LIKE DATA CARRIER AND METHOD FOR MANUFACTURING A CHIP MODULE**

(71) Applicant: Giesecke+Devrient ePayments GmbH, 81677 München (DE)
(72) Inventor: Carvajal, GOMIS MARC, 08820 El Prat de Llobregat (Barcelona) (ES); Constans, Nil, 08820 El Prat de Llobregat (Barcelona) (ES); Molina, Vidal Carles, 08820 El Prat de Llobregat (Barcelona) (ES)
(74) Representative: LKGLOBAL Partnerschaftsgesellschaft mbB

(57) **Abstract**

The invention relates to a chip module (1). The chip module (1) comprises an electronic component (10), a metallic element (20) having a first surface (21) and an electrical connection (30). The electronic component (10) is electrically connected to a point on the first surface (21) of the metallic element (20) via the electrical connection (30), wherein the electrical connection (30) is a multi-conductor electrical connection. The invention also relates to a card-like data carrier (100) comprising a chip module (1) and to a method for manufacturing a chip module (1).

## Description

The present invention generally relates to electrical connections for chip modules. In particular, the invention relates to a chip module, a card-like data carrier comprising a chip module, and a method for manufacturing a chip module.

Data carriers are used in a wide range of applications. For example, data carriers can be used for cashless payment of goods or services, for personal identification, or for access to Internet-based application programs. Accordingly, there are, for example, card-like data carriers in the form of chip cards in general, payment cards such as credit cards or debit cards, and personal ID cards or identity cards. Such data carriers usually comprise an electronic circuit which is connected to metal elements such as contact interfaces etc. via electrical connections. When these data carriers are used, stresses can act on the electrical connections, on the connection points between the metal elements and the electrical connections, and on the connection points between the electronic circuit and the electrical connections. Such stresses might negatively affect the stability of the electrical connections within the data carrier.

It may be seen as an object of the invention to improve the stability of electrical connections within chip modules for data carriers.

A chip module and a method for manufacturing a chip module according to the features of the independent claims are provided. Further embodiments of the invention are evident from the dependent claims, the Figures and the following description.

According to an aspect of the invention, a chip module is provided. The chip module comprises an electronic component, a metallic element having a first surface, and an electrical connection. The electronic component is electrically connected to a connection point on the first surface of the metallic element via the electrical connection. The electrical connection is a multi-conductor electrical connection.

In particular, the multi-conductor electrical connection connects the electronic component to the point, e.g., to a single point, on the first surface of the metallic element. Further electrical connections in the form of multi-conductor electrical connections may connect the electronic component to respective points on the first surface of the metallic element. The expression "multi-conductor electrical connection" may be understood in that one single electrical connection path or one single electrical connection branch comprises multiple conductors. In other words, the multiple conductors of the multi-conductor electrical connection may extend along a single electrical connection path or branch.

The present invention provides a chip module in which an electrical connection between a metal contact and an electronic circuit has an increased stability against external and environmental influences. In particular, the multi-conductor electrical connection of the inventive chip module has an increased strength in comparison to conventional electrical connections within chip modules such that the endurance and lifetime of electronic equipment of the chip module and thus also the endurance and lifetime of the data carrier in which the chip module is integrated may be extended.

In this regard, the multi-conductor electrical connection of the inventive chip module may have a considerably higher resistance against mechanical stresses that might occur especially inside the chip module of card-like data carriers. Since the electrical connection may have a bent shape when extending within the chip module, bending stresses may occur inside the electrical connection itself. However, as the electrical connection of the inventive chip module is a multi-conductor electrical connection, these bending stresses may be reduced or distributed within the electrical connection in a more efficient manner.

Furthermore, the electrical connection may be connected, e.g., soldered, to other components like the metallic element and the electronic component of the chip module. The corresponding connection points between these components and the electrical connection may be subject to stresses as well. However, as the electrical connection of the inventive chip module is a multi-conductor electrical connection, a better or optimized stress distribution at said connection points may be achieved.

The chip module may be part of a data carrier, in particular a card-like data carrier. The chip module may comprise several electronic elements and a support structure for supporting the electronic elements within the chip module. The electronic elements of the chip module may together form an electronic circuit. The chip module and the card body of the card-like data carrier into which the chip module is integrated may be manufactured separately.

The electronic component of the chip module may represent a chip element or chip of the chip module. The chip element or chip may comprise one or more CPUs (Central Processing Units), one or more GPUs (Graphics Processing Units) and/or a storage memory.

The metallic element may represent a metallic contact element for receiving contactors of an external device, for example an external reading device. The metallic element comprises the first (internal) surface to which the electronic component is electrically connected via the electrical connection. The metallic element may further comprise a second (external) surface which represents a metallic contact surface to which the above-mentioned contactors of the external device can be contacted for establishing a contact-based communication between the chip module and the external device.

The electrical connection of the chip module may extend within the chip module to electrically connect the electrical component with the metallic element. For example, the electrical connection may extend along one single connection path or branch between the metallic element and the electronic component. Furthermore, the electrical connection may extend in a bent shape within the chip module. The electrical connection is a multi-conductor electrical connection. In particular, the electrical connection may comprise two or more electrical conductors, herein also referred to as wires. Said electrical conductors may electrically connect the electrical component with the first surface of the metallic element. This means that all electrical conductors of the multi-conductor electrical connection may extend from a first connection point between the electrical conductors and the electronic component to a second connection point between the electrical conductors and the first surface of the metallic element.

In other words, the multi-conductor electrical connection, herein also referred to as multi-wire electrical connection, may comprise a first end that is connected to the electrical component at the first connection point and a second end that is connected to the first surface of the metallic element at the second connection point.

A solder connection or weld connection may connect the first end of the multi-conductor electrical connection to the electrical component. Alternatively or additionally, a solder connection or weld connection may connect the second end of the multi-conductor electrical connection to the first surface of the metallic element.

According to an embodiment, the multi-conductor electrical connection comprises a plurality of twisted electrical conductors.

In other words, the electrical conductors may be wound around each other such that a spirally shaped appearance of the multi-conductor electrical connection is present. This configuration may also be understood as a torsioned arrangement of conductors of the electrical connection. By arranging the electrical conductors in a twisted manner, shear forces over the surface of the electrical connection and/or the conductors can be avoided, thereby making the electrical connection and/or the conductors less susceptible of being broken. Furthermore, the stability of the overall multi-conductor electrical connection may be increased, basically without employing large amounts of further material. In particular, the form factor of the chip module can be maintained, while an increased stability and resistance of the electrical connections within the chip module against stresses can be achieved.

According to an embodiment, the multi-conductor electrical connection comprises a plurality of electrical conductors being arranged directly adjacent to each other.

For example, no further components such as electrical isolators or the like may be present within the multi-conductor electrical connection. In particular, the electrical conductors of the multi-conductor electrical connection do not comprise any isolating structures therebetween. Rather, the electrical conductors may lie directly adjacent to each other which means that the electrical conductors directly contact each other, for example along their entire extension between the electrical component and the point on the first surface of the metallic element. However, it is possible that the multi-conductor electrical connection in its entirety is enclosed by an electrical isolator. Furthermore, it is possible that the multi-conductor electrical connection in its entirety does not comprise any electrical isolator on its surface. The multi-conductor electrical connection in its entirety may partially or fully extend through an embedding component which is part of the chip module.

According to an embodiment, the multi-conductor electrical connection comprises a plurality of electrical conductors, each of the plurality of electrical conductors comprising a metallic material, wherein the metallic material is selected from a group, the croup comprising gold, silver, palladium and copper.

The electrical conductors of the multi-conductor electrical connection may comprise several conductors, wherein each of the conductors are made from the same material. However, it is possible that the multi-conductor electrical connection may comprise several conductors, wherein the conductors are made from two or more different materials, for example a combination of the above-mentioned materials.

According to an embodiment, the multi-conductor electrical connection has a total thickness of 20 µm to 25 µm, preferably of 20 µm to 23 µm, and more preferably of 23 µm.

Thus, the total thickness of the entire multi-conductor electrical connection can be kept small which avoids a rearrangement or resizing of any other components of the chip module. The above-mentioned exemplary thicknesses provide an improved strength of the multi-conductor electrical connection against mechanical stresses that may occur inside the chip module during use of the data carrier in which the chip module is integrated.

According to an embodiment, the multi-conductor electrical connection comprises a plurality of electrical conductors, each of the plurality of electrical conductors having a total thickness of 7 µm to 13 µm, preferably of 10 µm to 13 µm, and more preferably of 12 µm.

Thus, the total thickness of the individual electrical conductors can be kept small, while sufficient mechanical strength of the individual electrical conductors against mechanical stresses can be provided. The above-mentioned exemplary thicknesses of the individual electrical conductors provide an improved strength of the multi-conductor electrical connection against mechanical stresses that may occur inside the chip module during use of the data carrier in which the chip module is integrated.

According to an embodiment, the chip module further comprises an embedding component, wherein the electrical connection at least partially extends through the embedding component.

In other words, the electrical connection may be at least partially embedded within the embedding component. The embedding component may be in the form of a casting compound. It may contain a resin, e.g., an epoxy resin. After the electrical connection and the electrical component have been arranged in the chip module, the embedding component may be (partially) cast around these components. The embedding component can be directly connected or bonded to the first surface of the metallic element. An adhesive force can act between the embedding component and the first surface of the metallic element, holding the embedding compound and the metal element together.

According to an embodiment, the multi-conductor electrical connection is connected to the electronic component via a solder connection. Alternatively or additionally, the multi-conductor electrical connection is connected to the point on the first surface of the metallic element via a solder connection.

In this case, the solder connection between the multi-conductor electrical connection and the point on the first surface of the metallic element may encompass all electrical conductors of the multi-conductor electrical connection such that each individual electrical conductor of the multi-conductor electrical connection is electrically connected via the solder connection to the point on the first surface of the metallic element.

Furthermore, the solder connection between the multi-conductor electrical connection and the electronic component may encompass all electrical conductors of the multi-conductor electrical connection such that each individual electrical conductor of the multi-conductor electrical connection is electrically connected via the solder connection to the electronic component.

According to an aspect, a card-like data carrier comprising the chip module as described herein is provided.

The card-like data carrier may be a smart card, a payment card, a credit card, a debit card, an access card or an identity (ID) card. The card-like data carrier may provide the user with various functionalities like identification, authentication, payment or access to specified services, etc.

The card-like data carrier may comprise a card body. The card body may comprise a plurality of card layers which are connected to each other during a card manufacturing process. A lamination process may be used to form the card body from the plurality of card layers. The chip module may be integrated or embedded within the card body. For example, the chip module may be integrated or embedded within the card body after the chip module has been separately manufactured. A recess in the card body may be provided into which the chip module can be inserted during manufacturing of the card-like data carrier.

According to an aspect, a method for manufacturing a chip module is provided. A step of the method comprises providing an electronic component. Another step of the method comprises providing a metallic element having a first surface. Another step of the method comprises providing an electrical connection in the form of a multi-conductor electrical connection. Another step of the method comprises electrically connecting the electronic component to a connection point on the first surface of the metallic element via the electrical connection.

The method steps may be performed in the indicated order.

Exemplary embodiments of the invention are explained in more detail below with reference to schematic drawings.
- Fig. 1: shows a chip module.
- Fig. 2: shows an example of an electrical connection of the chip module of Fig. 1.
- Fig. 3: shows another example of an electrical connection of the chip module of Fig. 1.
- Fig. 4: shows a card-like data carrier comprising the chip module of Fig. 1.
- Fig. 5: shows a flow diagram of a method for manufacturing a chip module.

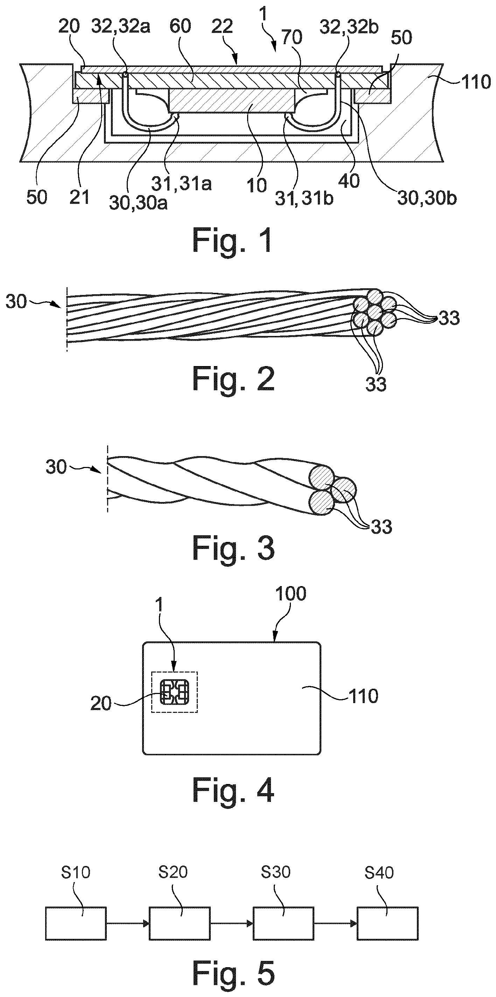

Fig. 1 shows chip module 1 for a data carrier, in particular for a card-like data carrier as it will be further described with respect to Fig. 4 below.

The chip module 1 comprises an electronic component 10 which in the present case may be a chip element or chip. The chip module 1 further comprises a metallic element 20 having a first surface 21 and a second surface 22. The chip module 1 further comprises a first electrical connection 30, 30a which electrically connects the electrical component 10 to a connection point on the first surface 21 of the metallic element 20. The first electrical connection 30, 30a is a multi-conductor electrical connection as it will be described in more detail with respect to Figures 2 and 3 below.

As can be seen from Fig. 1, the chip module 1 comprises a second electrical connection 30, 30b in addition to the first electrical connection 30, 30a. However, it is noted that the chip module 1 may comprise less or even more electrical connections than shown in Fig. 1. The first and second electrical connections 30a, 30b may each comprise or consist of a multi-conductor electrical connection which extends from the electrical component 10 to the metallic element 20, thereby electrically connecting the electrical component 10 and the metallic element 20.

The chip module 1 may be embedded within a card body 110 of a card-like data carrier. A cutout of the card body 110 is shown in Fig. 1. As can be seen in Fig. 1, the chip module 1 may be inserted or embedded within a cavity formed in the card body 110. An outer surface of the card body 110 may lie substantially flush with the second surface 22 of the metallic element 20. The card body 110 may include a plurality of card layers which, for example, may have been laminated with each other in a separate lamination process.

The metallic element 20 may represent a metallic contact element for receiving contactors of an external device (not shown in Fig. 1). As indicated above, metallic element 20 comprises the first (internal) surface 21 to which the electronic component 10 may be electrically connected via the first electrical connection 30a and/or the second electrical connection 30b. The second (external) surface 22 of the metallic element 20 may represent a metallic contact surface to which the above-mentioned contactors of the external device can be contacted for establishing a contact-based communication between the chip module 1 and the external device.

The electronic component 10, herein also referred to as chip element or chip, may comprise one or more CPUs (Central Processing Units), one or more GPUs (Graphics Processing Units) and/or a storage memory. The electrical component 10, the electrical connections 30, 30a, 30b and the metallic element 20 may together form an electronic circuit of the chip module 1.

The electronic component 10 and/or the electrical connections 30, 30a, 30b may be at least partially embedded in an embedding component 40. The embedding component 40 may comprise or consist of an epoxy resin. The embedding component 40 may be at least partly cast around the electronic component 10 and/or around the electrical connections 30, 30a, 30b.

A substrate 60 may be arranged between the metallic element 20 and the electronic component 10, wherein the substrate 60 may contain a PET (polyethylene terephthalate) substrate or a fiber composite material where fibers are arranged in a resin binder material, for example in an epoxy resin binder material. The substrate 60 may be connected to the card body 110 at connection locations 50, for example using an adhesive or hotmelt. An adhesive portion 70 may be arranged between the electronic component 10, the embedding component 40 and/or the substrate 60 in order to bond together said components and provide stability to the chip module 1.

The multi-conductor electrical connection of the first electrical connection 30, 30a may be connected to the electronic component 10 via a solder connection 31 at a first connection point 31a. Alternatively or additionally, the multi-conductor electrical connection of the first electrical connection 30, 30a may be connected to the first surface 21 of the metallic element 20 via a solder connection 32 at a second connection point 32a. In particular, the first electrical connection 30, 30a may comprise a first end that is connected to the electrical component 10 at the first connection point 31a and a second end that is connected to the first surface 21 of the metallic element 20 at the second connection point 32a.

Furthermore, the multi-conductor electrical connection of the second electrical connection 30, 30b may be connected to the electronic component 10 via a solder connection 31 at a third connection point 31b. Alternatively or additionally, the multi-conductor electrical connection of the second electrical connection 30, 30b may be connected to the first surface 21 of the metallic element 20 via a solder connection 32 at a fourth connection point 32b. In particular, the second electrical connection 30, 30b may comprise a first end that is connected to the electrical component 10 at the third connection point 31b and a second end that is connected to the first surface 21 of the metallic element 20 at the fourth connection point 32b.

As indicated above, each of the first and/or second electrical connection 30a, 3b may comprise a multi-conductor electrical connection, herein also referred to as multi-wire connection. The multi-conductor electrical connection comprises a plurality of individual electrical conductors. In an example, the multi-conductor electrical connection comprises two to ten electrical conductors. In preferred example, the multi-conductor electrical connection comprises two to seven electrical conductors. In an even more preferred example, the multi-conductor electrical connection comprises exactly three electrical conductors. A multi-conductor electrical connection that comprises exactly three electrical conductors may be specifically advantageous for the arrangement of the electrical connections 30 within the chip module 1 as shown in Fig. 1. The electrical connections 30 may be flexible so that they can be bent into a specified shape, for example into the shape as it is shown in Fig. 1.

Fig. 2 shows an example of an electrical connection 30 of the chip module 1 of Fig. 1. In particular, the electrical connection 30 comprises exactly seven individual electrical conductors 33. The seven electrical conductors 33 are twisted. In other words, the seven individual electrical conductors 33 are wound around each other along an electrical path of the electrical connection 30, wherein the electrical path may be curved such that the electrical connection 30 takes on the shape such as shown in Fig. 1. The seven electrical conductors 33 are arranged directly adjacent to each other which means that there are no other elements or components, like for instance an electrical isolator, between the electrical conductors 33. The seven electrical conductors 33 may comprise a metallic material, wherein the metallic material is selected from a group, the croup comprising gold, silver, palladium, copper, or a combination of two or more of these materials. In case of a combination, a first subset of the seven electrical conductors 33 may comprise another material than a second subset of the seven electrical conductors 33

Fig. 3 shows another example of an electrical connection 30 of the chip module 1 of Fig. 1. In particular, the electrical connection 30 comprises exactly three individual electrical conductors 33. The three electrical conductors 33 are twisted. In other words, the three individual electrical conductors 33 are wound around each other along an electrical path of the electrical connection 30, wherein the electrical path may be curved such that the electrical connection 30 takes on the shape such as shown in Fig. 1. The three electrical conductors 33 are arranged directly adjacent to each other which means that there are no other elements or components, like for instance an electrical isolator, between the electrical conductors 33. The three electrical conductors 33 may comprise a metallic material, wherein the metallic material is selected from a group, the croup comprising gold, silver, palladium, copper, or a combination of two or more of these materials. In case of a combination, a first subset of the three electrical conductors 33 may comprise another material than a second subset of the three electrical conductors 33
Fig. 4 shows a card-like data carrier 100 comprising the chip module 1 (indicated by dashed lines) of Fig. 1. As indicated with respect to Fig. 1 above, the card-like data carrier 100 comprises a card body 110. The card body 110 may comprise a plurality of card layers which are connected to each other during a card manufacturing process. The chip module 1 may be integrated or embedded within the card body 110 such that the metallic element 20 with the contact surface, e.g., including ISO contacts, is exposed on one side of the card-like data carrier 100. A recess in the card body 110 (cf. Fig. 1) may be provided into which the chip module 1 can be inserted during manufacturing of the card-like data carrier 100. The card-like data carrier 100, in particular the card body 110 of the card-like data carrier 100, may be present in the so-called ID-1 format.

Fig. 5 shows a flow diagram of a method for manufacturing a chip module, for example the chip module 1 as described with respect to Fig. 1.

A step S10 of the method comprises providing an electronic component 10. Another step S20 of the method comprises providing a metallic element 20 having a first surface 21. Another step S30 of the method comprises providing an electrical connection 30 in the form of a multi-conductor electrical connection. Another step S40 of the method comprises electrically connecting the electronic component 10 to a point on the first surface 21 of the metallic element 20 via the electrical connection 30.

## Claims

1. Chip module (1), comprising:
an electronic component (10);
a metallic element (20) having a first surface (21);
an electrical connection (30);
wherein the electronic component (10) is electrically connected to a connection point on the first surface (21) of the metallic element (20) via the electrical connection (30);
wherein the electrical connection (30) is a multi-conductor electrical connection.

2. The chip module (1) according to claim 1,
wherein the multi-conductor electrical connection comprises a plurality of twisted electrical conductors (33).

3. The chip module (1) according to any one of the preceding claims,
wherein the multi-conductor electrical connection comprises a plurality of electrical conductors (33) being arranged directly adjacent to each other.

4. The chip module (1) according to any one of the preceding claims,
wherein the multi-conductor electrical connection comprises a plurality of electrical conductors (33), each of the plurality of electrical conductors (33) comprising a metallic material, wherein the metallic material is selected from a group, the croup comprising gold, silver, palladium and copper.

5. The chip module (1) according to any one of the preceding claims,
wherein the multi-conductor electrical connection has a total thickness of 20 µm to 25 µm, preferably of 20 µm to 23 µm, and more preferably of 23 µm.

6. The chip module (1) according to any one of the preceding claims,
wherein the multi-conductor electrical connection comprises a plurality of electrical conductors (33), each of the plurality of electrical conductors (33) having a total thickness of 7 µm to 13 µm, preferably of 10 µm to 13 µm, and more preferably of 12 µm.

7. The chip module (1) according to any one of the preceding claims, comprising:
an embedding component (40);
wherein the electrical connection (30) at least partially extends through the embedding component (40).

8. The chip module (1) according to any one of the preceding claims,
wherein the multi-conductor electrical connection is connected to the electronic component (10) via a solder connection (31); and/or
wherein the multi-conductor electrical connection is connected to the connection point on the first surface (21) of the metallic element (20) via a solder connection (32).

9. Card-like data carrier (100) comprising a chip module (1) according to any one of the preceding claims.

10. A method for manufacturing a chip module (1), comprising:
providing an electronic component (10, S10);
providing a metallic element (20) having a first surface (21, S20);
providing an electrical connection (30) in the form of a multi-conductor electrical connection (S30);
electrically connecting the electronic component (10) to a connection point on the first surface (21) of the metallic element (20) via the electrical connection (30, S40).
